# EUROPEAN PATENT SPECIFICATION

(11) **EP 3 332 623 B1**
(45) Date of publication and mention of the grant of the patent: **24.03.2021**
(21) Application number: 17726342.3
(22) Date of filing: 10.05.2017
(51) Int. Cl.: H05K 13/00, H05K 13/02, H05K 13/04

(54) **DEVICE AND METHOD FOR DETACHING RADIAL ELECTRONIC COMPONENTS FROM A COMPONENT TAPE**
VORRICHTUNG UND VERFAHREN ZUM ABLÖSEN VON RADIALEN ELEKTRONISCHEN KOMPONENTEN VON EINEM KOMPONENTENBAND
DISPOSITIF ET PROCÉDÉ POUR DÉTACHER DES COMPOSANTS ÉLECTRONIQUES RADIAUX D'UNE BANDE DE COMPOSANTS

(30) Priority: 12.05.2016 FI 20165404
(43) Date of publication of application: 13.06.2018
(73) Proprietor: Salcomp Oyj, 24101 Salo (FI)
(72) Inventor: VALJUS, Simo, 08200 Lohja (FI); SAVOLAINEN, Kari, 03220 Tervalampi (FI); KUOSMANEN, Pertti, 08350 Lohja (FI); KANTOLA, Juha, 08700 Lohja (FI); MÄKELÄ, Vesa, 08200 Lohja (FI); NUMMENPÄÄ, Pekka, 24260 Salo (FI); HÄRKÄLÄ, Pekka, 08350 Lohja (FI)
(74) Representative: Berggren Oy, Turku
(86) International application number: PCT/FI2017/050363
(87) International publication number: WO 2017/194840

(56) References cited:
- WO-A1-2015/136600
- JP-A- 2015 211 214
- US-A- 4 293 999
- US-A- 4 356 949

## Description

### TECHNICAL FIELD OF THE INVENTION

The present invention relates to a device for detaching radial electronic components from a component tape according to the preamble of the appended independent claim.

### BACKGROUND OF THE INVENTION

Component tapes are widely used in electronics industry to carry axial and radial electronic components, such as resistors, capacitors and inductors. The axial electronic components are attached between two component tapes, whereas the radial electronic components are attached to only one component tape. The electronic components are attached to the component tape(s) at their leads.

The electronic components are typically detached from the component tape(s) one component at a time. This is done by cutting the leads of the electronic component using a cutting device. Examples of cutting devices are described, for example, in JP 2015211214 A and US 4356949 A.

An example of a known device for cutting leads of radial electronic components comprises two cutting blades of which one is fixed and the other is movable. A radial electronic component to be detached from a component tape is fed between the cutting blades so that the leads of the radial electronic component may be cut by moving the movable cutting blade against the fixed cutting blade. A problem associated with this known cutting device is that it is difficult to cut the leads of different radial electronic components to the same length. This is due to the fact that the radial electronic components are typically located at different heights relative to the component tape. The height variation of the radial electronic components in the component tape is typically 1-2 mm.

### OBJECTIVES OF THE INVENTION

It is the main objective of the present invention to reduce or even eliminate the prior art problems presented above.

It is an objective of the present invention to provide a device for detaching radial electronic components from a component tape easily and accurately. In more detail, it is an objective of the invention to provide a device enabling to detach radial electronic components from a component tape in such a manner that the length variation of the leads of different radial electronic components is minimal, i.e. the leads of the detached electronic components have essentially the same length.

In order to realise the above-mentioned objectives, the device according to the invention is characterised by what is presented in the characterising part of the appended independent claim. Advantageous embodiments of the invention are described in the dependent claims.

### DESCRIPTION OF THE INVENTION

A typical device according to the invention for detaching radial electronic components from a component tape comprises a cutter for cutting leads of a radial electronic component, a limiter for aligning the radial electronic component with respect to the cutter in a first direction, and means for arranging a body of the radial electronic component against the limiter.

The device according to the invention is used to detach radial electronic components from a component tape one component at a time. A radial electronic component is detached from the component tape by cutting its leads with the cutter. Before the cutting, the body of the radial electronic component, which has been fed to the cutter, is arranged against, i.e. in contact with, the limiter. With the limiter the radial electronic component can be aligned with respect to the cutter in a correct position in the first direction. Preferably, the end of the component body from which end the leads of the radial electronic component project is arranged against the limiter. The body of the radial electronic component can be arranged against the limiter by moving the radial electronic component in the first direction or by moving the limiter in a direction opposite to the first direction. The radial electronic component can be moved in the first direction, for example, by pushing the component body or by pulling the component tape. The body of the radial electronic component is kept against the limiter during cutting of the leads. As a result of this the leads of the radial electronic component can be cut accurately to a desired length, which is defined by the distance between the limiter and the cutter.

The limiter is preferably attached to the cutter. The limiter can be a separate part that has been attached to the cutter or it can be an integral part of the cutter. The cutter may comprise one or more cutting blades and the limiter can be attached to one of the cutting blades. The distance between the limiter and the cutter can be adjustable so that the lead length of the detached radial electronic components can be changed depending on the requirements.

The radial electronic components in the component tape can be fed to the cutter using a feeder. The feeder is preferably configured to feed the radial electronic components to the cutter in a direction that is essentially perpendicular to the first direction. This direction is called the feeding direction. The cutter is preferably configured to cut the leads of the radial electronic components in a direction that is essentially perpendicular to the first direction as well as the feeding direction. This direction is called the cutting direction.

By a radial electronic component is meant an electronic component having leads that project essentially in parallel (side by side) from the same end of a component body, rather than from opposite ends of the component body. The radial electronic component typically comprises two leads, but it can alternatively comprise three, four, five or more than five leads. When placed on a circuit board, a radial electronic component stands up perpendicularly from the circuit board. The parallel leads projecting from a single mounting surface gives a radial electronic component an overall plugin nature, facilitating its use in high-speed automated component insertion machines.

The radial electronic components, such as capacitors and inductors, are arranged successively on the component tape. The component pitch and the lead spacing on the component tape can vary depending on the electronic components used. The radial electronic components are attached to the component tape at their leads. The component tape may be wound on a reel or packed in a box from which the radial electronic components are sequentially delivered to the cutter to be detached one component at a time from the component tape. The component tape may comprise evenly spaced sprocket holes that can be used to feed the component tape to the cutter. The pitch of sprocket hole can vary, but it is preferably equal to the component pitch. The component tape can be, for example, a punched paper tape.

An advantage of the invention is that it enables to detach radial electronic components from a component tape easily and accurately. Another advantage of the invention is that it enables to detach radial electronic components from a component tape in such a manner that the length variation of the leads of different radial electronic components is minimal, i.e. the leads of the detached electronic components have essentially the same length.

According to an embodiment of the invention the means comprises a pushing head for pushing the body of the radial electronic component, and a first actuator attached to the pushing head and configured to move the pushing head. The pushing head is arranged to push the first end of the component body, which first end is opposite to the second end from which the leads of the radial electronic component project. When the radial electronic component to be detached from the component tape has been fed to the cutter, the first actuator moves the pushing head in the first direction until the body of the radial electronic component comes against the limiter. Preferably, the pushing head is arranged to push the second end of the component body against the limiter and to keep the second end of the component body against the limiter during cutting of the leads of the radial electronic component. After the leads of the radial electronic component have been cut, the first actuator moves the pushing head in a direction opposite to the first direction. The first actuator can be, for example, a pneumatic cylinder or an electromagnetic cylinder.

According to an embodiment of the invention the limiter is attached to the cutter. The distance between the limiter and the cutter may be adjustable so that the lead length of the detached radial electronic components can be changed depending on the requirements.

According to an embodiment of the invention the means comprises a second actuator attached to the cutter and configured to move the cutter. The second actuator is preferably configured to move the cutter in a direction opposite to the first direction. When the limiter is attached to the cutter, the body of the radial electronic component can be arranged against the limiter by moving the cutter with the second actuator. The second actuator can be, for example, a pneumatic cylinder or an electromagnetic cylinder.

According to the invention the device comprises alignment pins for aligning the radial electronic component with respect to the cutter in a second direction perpendicular to the first direction, and a third actuator attached to the alignment pins and configured to move first ends of the alignment pins into and out of sprocket holes of the component tape. The alignment pins are moved into the sprocket holes of the component tape after the radial electronic component to be detached from the component tape has been fed to the cutter. After the leads of the radial electronic component have been cut, the alignment pins are moved out of the sprocket holes. The purpose of the alignment pins is to align the radial electronic component into a correct position with respect to the cutter in the second direction. Preferably, the device comprises two alignment pins, the distance of which is a multiple of the pitch of sprocket hole. The device may alternatively comprise more than two alignment pins, for example, three, four, five or more than five alignment pins. The third actuator can be, for example, a pneumatic cylinder or an electromagnetic cylinder.

According to the invention the alignment pins are bendable. This enables the component tape to move in the first direction when the radial electronic component is pushed against the limiter. The bendable alignment pins thus prevent the component tape from being torn.

According to an embodiment of the invention the alignment pins are pivoted at their second ends. When the radial electronic component is moved in the first direction, the alignment pins can pivot about their pivot points. This enables the component tape to move in the first direction when the radial electronic component is pushed or pulled against the limiter. The pivoting of the alignment pins thus prevents the component tape from being torn.

According to an embodiment of the invention the means comprises a fourth actuator attached to the alignment pins and configured to turn the alignment pins about their pivot points. The alignment pins are pivoted at their second ends. Using the fourth actuator the alignment pins can be turned in such a manner that the component tape is moved in the first direction. By turning the alignment pins, the radial electronic component to be detached from the component tape can be pulled against the limiter. The fourth actuator can be, for example, a pneumatic cylinder or an electromagnetic cylinder.

According to an embodiment of the invention the means comprises a fifth actuator attached to the alignment pins and configured to move the alignment pins. Using the fifth actuator the alignment pins can be moved in the first direction whereby the component tape is also moved in the first direction. By moving the alignment pins in the first direction, the radial electronic component to be detached from the component tape can be pulled against the limiter. The fifth actuator can be, for example, a pneumatic cylinder or an electromagnetic cylinder.

According to an embodiment of the invention the device comprises springs attached to the alignment pins and configured to produce a force that moves the alignment pins towards their initial positions. The springs are used to return the alignment pins to their initial positions after the radial electronic component has been detached from the component tape. The springs are preferably used in devices where the alignment pins are bendable or pivoted.

According to an embodiment of the invention the cutter comprises two opposing cutting blades of which at least one is movable. Depending on the application one of the cutting blades is fixed and the other is movable, or both of the cutting blades are movable. The cutting blade(s) is(are) preferably moved in a direction which is perpendicular to the first direction.

According to an embodiment of the invention the limiter is attached to one of the two opposing cutting blades. The limiter may be integrated with the cutting blade. If one of the cutting blades is fixed, the limiter is preferably attached to the fixed cutting blade.

According to an embodiment of the invention the cutter comprises a sixth actuator attached to a movable cutting blade and configured to move the movable cutting blade. The sixth actuator is configured to move the movable cutting blade back and forth in a third direction perpendicular to the first and the second direction. If both of the cutting blades are movable the sixth actuator is attached to both of them. In this case, the sixth actuator is configured to move the cutting blades towards and away from each other. The sixth actuator can be, for example, a pneumatic cylinder or an electromagnetic cylinder.

According to an embodiment of the invention the limiter is a plate arranged perpendicular to the first direction. The plate is preferably attached to a cutting blade of the cutter. Preferably, the plate is attached on that side of the cutting blade which is closer to the body of the radial electronic component to be detached.

According to an embodiment of the invention the device comprises a feeder for feeding the component tape to the cutter. The feeder is configured to feed the radial electronic component in the second direction to the cutter. The feeder can feed the component tape to the cutter in such a manner that radial electronic components can be detached from the component tape one component at a time. The component tape may be wound on a reel or packed in a box from which the component tape containing the radial electronic components is delivered to the cutter. The second direction, i.e. the feeding direction, is perpendicular to the first direction.

The exemplary embodiments of the invention presented in this text are not interpreted to pose limitations to the applicability of the appended claims. The verb "to comprise" is used in this text as an open limitation that does not exclude the existence of also unrecited features. The features recited in the dependent claims are mutually freely combinable unless otherwise explicitly stated.

### BRIEF DESCRIPTION OF THE DRAWINGS

- Fig. 1: illustrates a device for detaching radial electronic components from a component tape,
- fig. 2: illustrates a device according to a first embodiment of the invention,
- fig. 3: illustrates a device according to a second embodiment of the invention, and
- fig. 4: illustrates a device according to a third embodiment of the invention.

### DETAILED DESCRIPTION OF THE DRAWINGS

The same reference signs are used of the same or like components in different embodiments.

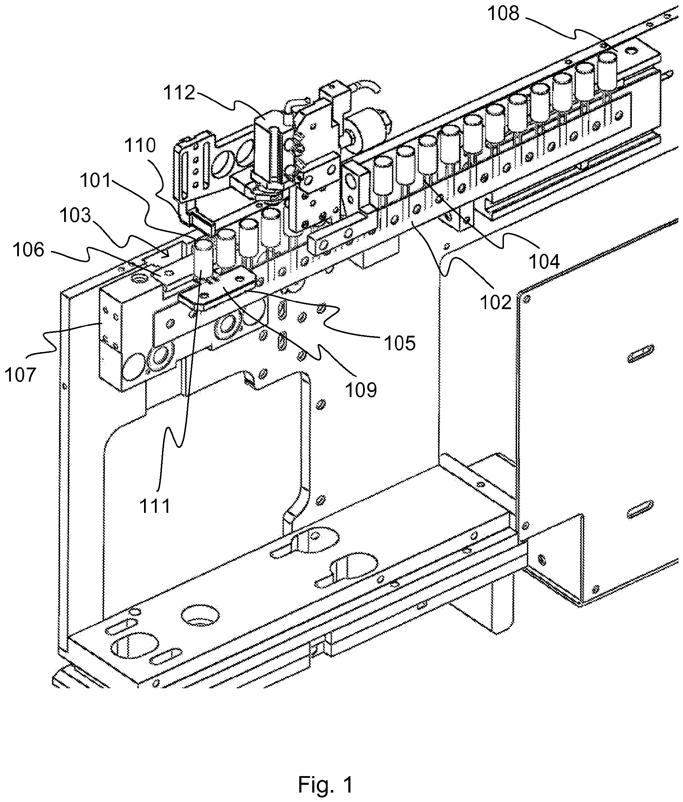

Fig. 1 illustrates a device for detaching radial electronic components 101 from a component tape 102. The device comprises a cutter 103 for cutting leads 104 of the radial electronic components 101. The cutter 103 comprises two opposing cutting blades 105 and 106, and an actuator 107 for moving the cutting blades 105 and 106 towards and away from each other. The radial electronic components 101 in the component tape 102 are fed to the cutter 103 using a feeder 108. The feeder 108 is configured to feed the component tape 102 to the cutter 103 in such a manner that the radial electronic components 101 can be detached from the component tape 102 one component at a time.

The device of fig. 1 comprises a limiter 109 for aligning the radial electronic component 101 with respect to the cutter 103 in a first direction. The limiter 109 is a plate that is attached to the upper side of the cutting blade 105. The device further comprises a pushing head 110 for pushing a body 111 of the radial electronic component 101 against the limiter 109, and an actuator 112 for moving the pushing head 110. The pushing head 110 is arranged to push the component body 111 at its end in such a manner that the other end from which the leads 104 of the radial electronic component 101 project can be pushed against the limiter 109 and to keep it in contact with the limiter 109 during cutting of the leads 104 of the radial electronic component 101.

The device of fig. 1 is used to detach radial electronic components 101 from the component tape 102 one component at a time. When the radial electronic component 101 to be detached from the component tape 102 has been fed to the cutter 103, the actuator 112 moves the pushing head 110 in the first direction until the body 111 of the radial electronic component 101 comes against the limiter 109. The pushing head 110 keeps the component body 111 against the limiter 109 while the leads 104 of the radial electronic component 101 are cut by moving the cutting blades 105 and 106 against each other with the actuator 107. After the leads 104 of the radial electronic component 101 have been cut, the actuator 107 moves the cutting blades 105 and 106 away from each other and the actuator 112 moves the pushing head 110 in a direction opposite to the first direction. Then the feeder 108 moves the next radial electronic component 101 in the component tape 102 to the cutter 103 to be detached.

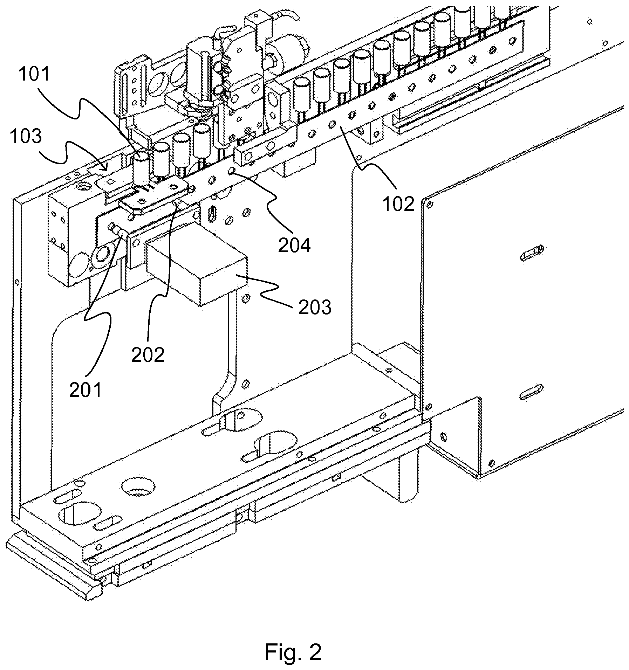

Fig. 2 illustrates a device according to a first embodiment of the invention for detaching radial electronic components 101 from a component tape 102. The device of fig. 2 differs from the device of fig. 1 in that the device further comprises alignment pins 201 and 202 for aligning the radial electronic component 101 with respect to the cutter 103 in a second direction that is perpendicular to the first direction, and an actuator 203 for moving first ends of the alignment pins 201 and 202 into and out of sprocket holes 204 of the component tape 102. The alignment pins 201 and 202 are moved into the sprocket holes 204 of the component tape 102 after the radial electronic component 101 to be detached from the component tape 102 has been fed between the cutting blades 105 and 106 of the cutter 103. After the leads 104 of the radial electronic component 101 have been cut, the alignment pins 201 and 202 are moved out of the sprocket holes 204. The alignment pins 201 and 202 are pivoted at their second ends. When the radial electronic component 101 is moved in the first direction using the pushing head 110, the alignment pins 201 and 202 can pivot about their pivot points. This enables the component tape 102 to move in the first direction when the radial electronic component 101 is moved against the limiter 109. The device also comprises springs (not shown in fig. 2) attached to the alignment pins 201 and 202 and configured to produce a force that moves the alignment pins 201 and 202 towards their initial positions. The springs are used to return the alignment pins 201 and 202 to their initial positions after the radial electronic component 101 has been detached from the component tape 102.

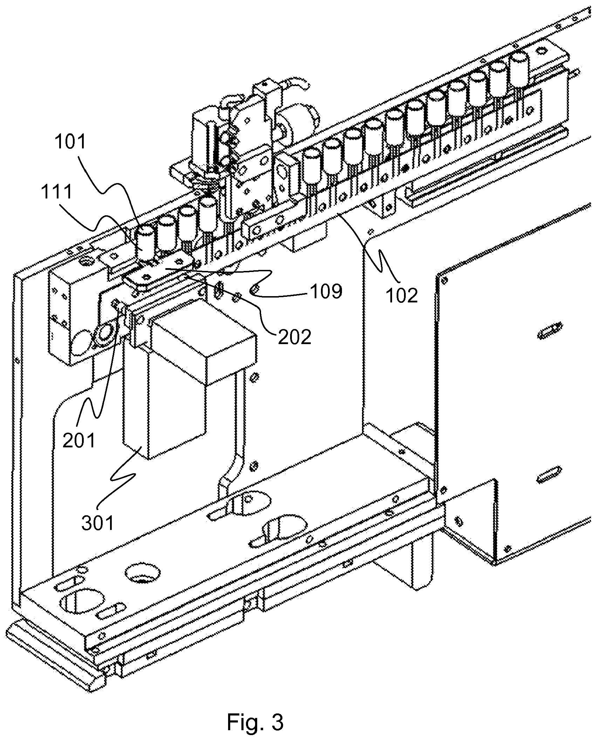

Fig. 3 illustrates a device according to a second embodiment of the invention for detaching radial electronic components 101 from a component tape 102. The device of fig. 3 differs from the device of fig. 2 in that the device comprises different means for arranging a body 111 of the radial electronic component 101 against the limiter 109. The device of fig. 3 comprises an actuator 301 for turning the alignment pins 201 and 202 about their pivot points. Using the actuator 301 the alignment pins 201 and 202 can be turned in such a manner that the component tape 102 is moved in the first direction. By turning the alignment pins 201 and 202, the radial electronic component 101 to be detached from the component tape 102 can be pulled against the limiter 109.

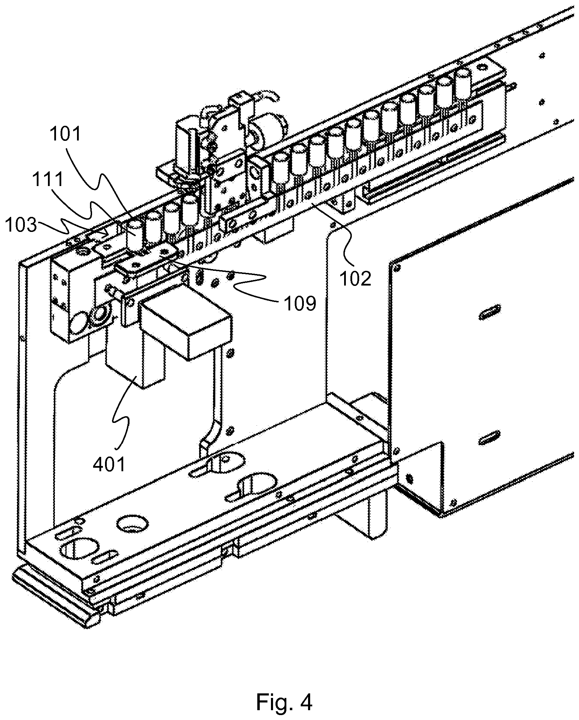

Fig. 4 illustrates a device according to a third embodiment of the invention for detaching radial electronic components 101 from a component tape 102. The device of fig. 4 differs from the device of fig. 2 in that the device comprises different means for arranging a body 111 of the radial electronic component 101 against the limiter 109. The device of fig. 4 comprises an actuator 401 attached to the cutter 103 and configured to move the cutter 103 to which the limiter 109 is attached. The body 111 of the radial electronic component 101 can be arranged against the limiter 109 by moving the cutter 103 with the actuator 401 in a direction opposite to the first direction.

Only advantageous exemplary embodiments of the invention are described in the figures. It is clear to a person skilled in the art that the invention is not restricted only to the examples presented above, but the invention may vary within the limits of the claims presented hereafter. Some possible embodiments of the invention are described in the dependent claims, and they are not to be considered to restrict the scope of protection of the invention as such.

## Claims

1. A device for detaching radial electronic components (101) from a component tape (102), comprising:
- a cutter (103) for cutting leads (104) of a radial electronic component (101),
- a limiter (109) for aligning the radial electronic component (101) with respect to the cutter (103) in a first direction,
- means (110, 112, 301, 401) for arranging a body (111) of the radial electronic component (101) against the limiter (109),
- alignment pins (201, 202) for aligning the radial electronic component (101) with respect to the cutter (103) in a second direction perpendicular to the first direction, and
- a third actuator (203) attached to the alignment pins (201, 202) and configured to move first ends of the alignment pins (201, 202) into and out of sprocket holes (204) of the component tape (102),
**characterised in that** the alignment pins (201, 202) are bendable.

2. The device according to claim 1, **characterised in that** the means comprises a pushing head (110) for pushing the body (111) of the radial electronic component (101), and a first actuator (112) attached to the pushing head (110) and configured to move the pushing head (110).

3. The device according to claim 1 or 2, **characterised in that** the limiter (109) is attached to the cutter (103).

4. The device according to claim 3, **characterised in that** the means comprises a second actuator (401) attached to the cutter (103) and configured to move the cutter (103).

5. The device according to any of the preceding claims, **characterised in that** the alignment pins (201, 202) are pivoted at their second ends.

6. The device according to claim 5, **characterised in that** the means comprises a fourth actuator (301) attached to the alignment pins (201, 202) and configured to turn the alignment pins (201, 202) about their pivot points.

7. The device according to any of the preceding claims, **characterised in that** the means comprises a fifth actuator attached to the alignment pins (201, 202) and configured to move the alignment pins (201, 202).

8. The device according to any of the preceding claims, **characterised in that** the device comprises springs attached to the alignment pins (201, 202) and configured to produce a force that moves the alignment pins (201, 202) towards their initial positions.

9. The device according to any of the preceding claims, **characterised in that** the cutter (103) comprises two opposing cutting blades (105, 106) of which at least one is movable.

10. The device according to claim 9, **characterised in that** the limiter (109) is attached to one of the two opposing cutting blades (105, 106).

11. The device according to any of the preceding claims, **characterised in that** the device comprises a feeder (108) for feeding the component tape (102) to the cutter (103).

## Patentansprüche

1. Vorrichtung zum Abnehmen radialer elektronischer Bauteile (101) von einem Bauteilband (102), umfassend:
- einen Schneider (103) zum Schneiden von Leitungen (104) eines radialen elektronischen Bauteils (101),
- einen Begrenzer (109) zum Ausrichten des radialen elektronischen Bauteils (101) in Bezug auf den Schneider (103) in einer ersten Richtung,
- Mittel (110, 112, 301, 401) zum Anordnen eines Körpers (111) des radialen elektronischen Bauteils (101) gegen den Begrenzer (109),
- Ausrichtungsstifte (201, 202) zum Ausrichten des radialen elektronischen Bauteils (101) in Bezug auf den Schneider (103) in einer zweiten Richtung senkrecht zur ersten Richtung, und
- einen dritten Aktuator (203), der an den Ausrichtungsstiften (201, 202) angebracht und konfiguriert ist, um die ersten Enden der Ausrichtungsstifte (201, 202) in und aus den Zahnradlöchern (204) des Bauteilbands (102) zu bewegen, **dadurch gekennzeichnet, dass** die Ausrichtungsstifte (201, 202) biegbar sind.

2. Vorrichtung nach Anspruch 1, **dadurch gekennzeichnet, dass** das Mittel einen Druckkopf (110) zum Drücken des Körpers (111) des radialen elektronischen Bauteils (101) und einen ersten Aktuator (112) umfasst, der an dem Druckkopf (110) angebracht und konfiguriert ist, um den Druckkopf (110) zu bewegen.

3. Vorrichtung nach Anspruch 1 oder 2, **dadurch gekennzeichnet, dass** der Begrenzer (109) am Schneider (103) angebracht ist.

4. Vorrichtung nach Anspruch 3, **dadurch gekennzeichnet, dass** die Mittel einen zweiten Aktuator (401) umfasst, der an dem Schneider (103) angebracht und konfiguriert ist, um den Schneider (103) zu bewegen.

5. Vorrichtung nach einem der vorhergehenden Ansprüche, **dadurch gekennzeichnet, dass** die Ausrichtungsstifte (201, 202) an ihren zweiten Enden gedreht werden.

6. Vorrichtung nach Anspruch 5, **dadurch gekennzeichnet, dass** die Mittel einen vierten Aktuator (301) umfasst, der an den Ausrichtungsstiften (201, 202) angebracht und konfiguriert ist, um die Ausrichtungsstifte (201, 202) um ihre Drehpunkte zu drehen.

7. Vorrichtung nach einem der vorhergehenden Ansprüche, **dadurch gekennzeichnet, dass** die Einrichtung einen fünften Aktuator umfasst, der an den Ausrichtungsstiften (201, 202) angebracht und konfiguriert ist, um die Ausrichtungsstifte (201, 202) zu bewegen.

8. Vorrichtung nach einem der vorhergehenden Ansprüche, **dadurch gekennzeichnet, dass** die Vorrichtung Federn umfasst, die an den Ausrichtungsstiften (201, 202) angebracht und konfiguriert sind, um eine Kraft zu erzeugen, die die Ausrichtungsstifte (201, 202) zu ihren Ausgangspositionen bewegt.

9. Vorrichtung nach einem der vorhergehenden Ansprüche, **dadurch gekennzeichnet, dass** der Schneider (103) zwei gegenüberliegende Schneidklingen (105, 106) umfasst, von denen mindestens eine beweglich ist.

10. Vorrichtung nach Anspruch 9, **dadurch gekennzeichnet, dass** der Begrenzer (109) an einer der beiden gegenüberliegenden Schneidklingen (105, 106) angebracht ist.

11. Vorrichtung nach einem der vorhergehenden Ansprüche, **dadurch gekennzeichnet, dass** die Vorrichtung eine Zuführung (108) zum Zuführen des Bauteilbands (102) zum Schneider (103) umfasst.

## Revendications

1. Dispositif pour détacher des composants électroniques radiaux (101) d'une bande de composants (102), comprenant :
- un élément de coupe (103) pour couper des conducteurs (104) d'un composant électronique radial (101),
- un limiteur (109) pour aligner le composant électronique radial (101) par rapport à l'élément de coupe (103) dans une première direction,
- un moyen (110, 112, 301, 401) pour agencer un corps (111) du composant électronique radial (101) contre le limiteur (109),
- des goupilles d'alignement (201, 202) pour aligner le composant électronique radial (101) par rapport à l'élément de coupe (103) dans une seconde direction perpendiculaire à la première direction, et
- un troisième actionneur (203) fixé aux goupilles d'alignement (201, 202) et conçu pour déplacer des premières extrémités des goupilles d'alignement (201, 202) à l'intérieur et à l'extérieur des perforations d'entraînement (204) de la bande de composants (102),
**caractérisé en ce que** les goupilles d'alignement (201, 202) peuvent être pliées.

2. Dispositif selon la revendication 1, **caractérisé en ce que** le moyen comprend une tête de poussée (110) pour pousser le corps (111) du composant électronique radial (101), et un premier actionneur (112) fixé à la tête de poussée (110) et conçu pour déplacer la tête de poussée (110) .

3. Dispositif selon la revendication 1 ou 2, **caractérisé en ce que** le limiteur (109) est fixé à l'élément de coupe (103) .

4. Dispositif selon la revendication 3, **caractérisé en ce que** le moyen comprend un deuxième actionneur (401) fixé à l'élément de coupe (103) et conçu pour déplacer l'élément de coupe (103).

5. Dispositif selon l'une quelconque des revendications précédentes, **caractérisé en ce que** les goupilles d'alignement (201, 202) sont pivotées au niveau de leurs secondes extrémités.

6. Dispositif selon la revendication 5, **caractérisé en ce que** le moyen comprend un quatrième actionneur (301) fixé aux goupilles d'alignement (201, 202) et conçu pour tourner les goupilles d'alignement (201, 202) autour de leurs points de pivotement.

7. Dispositif selon l'une quelconque des revendications précédentes, **caractérisé en ce que** le moyen comprend un cinquième actionneur fixé aux goupilles d'alignement (201, 202) et conçu pour déplacer les goupilles d'alignement (201, 202).

8. Dispositif selon l'une quelconque des revendications précédentes, **caractérisé en ce que** le dispositif comprend des ressorts fixés aux goupilles d'alignement (201, 202) et conçus pour produire une force qui déplace les goupilles d'alignement (201, 202) vers leurs positions initiales.

9. Dispositif selon l'une quelconque des revendications précédentes, **caractérisé en ce que** l'élément de coupe (103) comprend deux lames de coupe (105, 106) opposées dont au moins une est mobile.

10. Dispositif selon la revendication 9, **caractérisé en ce que** le limiteur (109) est fixé à une des deux lames de coupe (105, 106) opposées.

11. Dispositif selon l'une quelconque des revendications précédentes, **caractérisé en ce que** le dispositif comprend un organe d'alimentation (108) pour fournir la bande de composants (102) à l'élément de coupe (103).
